(19) **Europäisches Patentamt European Patent Office Office européen des brevets**

(11) **EP 4 611 211 A1**

(12) **EUROPEAN PATENT APPLICATION**
published in accordance with Art. 153(4) EPC

(43) Date of publication:
03.09.2025 Bulletin 2025/36

(21) Application number: 23882369.4

(22) Date of filing: 04.10.2023

(51) International Patent Classification (IPC):
*H02J 7/00* (2006.01)   *B60L 3/00* (2019.01)
*B60L 50/60* (2019.01)   *B60L 58/12* (2019.01)
*B60L 58/16* (2019.01)   *E02F 9/00* (2006.01)
*G01R 31/388* (2019.01)   *G01R 31/392* (2019.01)
*H01M 10/48* (2006.01)

(52) Cooperative Patent Classification (CPC):
**B60L 3/00; B60L 50/60; B60L 58/12; B60L 58/16; E02F 9/00; G01R 31/388; G01R 31/392; H01M 10/48; H02J 7/00;** Y02E 60/10

(86) International application number:
**PCT/JP2023/036274**

(87) International publication number:
**WO 2024/090160 (02.05.2024 Gazette 2024/18)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: 28.10.2022 JP 2022173100

(71) Applicant: Hitachi Construction Machinery Co., Ltd.
**Tokyo 110-0015 (JP)**

(72) Inventors:
• **KAMIJOU, Takashi**
  **Tokyo 100-8280 (JP)**
• **KOMATSU, Daiki**
  **Tokyo 100-8280 (JP)**
• **TAKEUCHI, Ken**
  **Tsuchiura-shi, Ibaraki 300-0013 (JP)**
• **TANIGAKI, Kenta**
  **Tsuchiura-shi, Ibaraki 300-0013 (JP)**

(74) Representative: **MERH-IP Matias Erny Reichl Hoffmann**
**Patentanwälte PartG mbB**
**Paul-Heyse-Straße 29**
**80336 München (DE)**

(54) **ELECTRIC WORK MACHINE**

(57) Provided is an electrically driven work machine capable of increasing estimation accuracy of a remaining charge time or a remaining discharge time of a secondary battery. An electrically driven excavator includes a secondary battery, a battery management unit, and a vehicle control unit. The vehicle control unit predicts a transition of a temperature of the secondary battery on the basis of the temperature and a state of charge of the secondary battery detected by the battery management unit, predicts a transition of a current of the secondary battery on the basis of the predicted transition of the temperature of the secondary battery, and estimates the remaining charge time or the remaining discharge time of the secondary battery on the basis of the predicted transition of the current of the secondary battery.

[FIG. 2]

EP 4 611 211 A1

## EP 4 611 211 A1

**Description**

Technical Field

The present invention relates to an electrically driven work machine.

Background Art

An electrically driven excavator, which is one of the electrically driven work machines, includes, for example, a secondary battery (in details, an electricity storage device configured by a lithium ion battery, a lead battery, or the like) which stores electric power, an electrically driven motor which is driven by the electric power supplied from the secondary battery via an inverter, a hydraulic pump which is driven by the electrically driven motor, a hydraulic actuator which is driven by a pressurized fluid from the hydraulic pump, and a charger which uses electric power supplied from an external power supply to charge the secondary battery. Moreover, there has been proposed, as a configuration for supporting an operator, a controller which computes a remaining charge time at a charge time of the secondary battery or a remaining discharge time at a discharge time of the secondary battery (in other words, a remaining operation time at an operation time of the electrically driven excavator), and a display device which displays the remaining charge time or the remaining discharge time computed by the controller.

In Patent Document 1, there is disclosed a method of estimating a required time (a remaining charge time) for charging a secondary battery through a constant current charge method (in details, a method which sequentially executes a plurality of constant current charge steps). In this estimation method, the present state of charge of the secondary battery is acquired. Moreover, on the basis of the present temperature of the secondary battery, an achievable state of charge of each constant current charge step is acquired. After that, a required time of each constant current charge step is computed on the basis of the present state of charge of the secondary battery and the achievable state of charge of each constant current charge step, and the remaining charge time which is a sum of the required times is computed.

Prior Art Document

Patent Document

Patent Document 1: JP-2020-036393-A

Summary of the Invention

Problem to be Solved by the Invention

Incidentally, at the charge time of the secondary battery, as the charge time elapses, the temperature of the secondary battery increases. In the charge method according to the Patent Document **1,** the current of the secondary battery in each constant current charge step is fixed and the current of the secondary battery is not changed according to the change in temperature of the secondary battery. However, in terms of simultaneously suppressing deterioration of the secondary battery and reducing the charge time, it is preferred that the current of the secondary battery be changed according to the change in temperature of the secondary battery. In this case, as in the estimation method according to Patent Document **1,** the remaining charge time of the secondary battery is estimated only from the present temperature of the secondary battery without considering the change in temperature of the secondary battery, estimation accuracy thereof decreases.

At the discharge time of the secondary battery, as the discharge time elapses, the temperature of the secondary battery increases. Thus, in terms of simultaneously suppressing the deterioration of the secondary battery and increasing power of the electrically driven motor, it is preferred that the current of the secondary battery be changed according to the change in temperature of the secondary battery. In this case, the remaining discharge time of the secondary battery is estimated only from the present temperature of the secondary battery without considering the change in temperature of the secondary battery, estimation accuracy thereof decreases.

The present invention has been made in view of the matter described above and has an object to provide an electrically driven work machine capable of increasing estimation accuracy of a remaining charge time or a remaining discharge time of a secondary battery.

Means for Solving the Problem

In order to achieve the objective described above, the present invention is an electrically driven work machine including: a secondary battery; and a battery management unit that detects at least either a voltage or a state of charge of the secondary battery and a temperature of the secondary battery, the electrically driven work machine includes a vehicle control unit that manages charge and discharge of the secondary battery, and the vehicle control unit is configured to predict a transition of the temperature of the secondary battery on the basis of the temperature and the voltage or the state of charge of the secondary battery detected by the battery management unit, predict a transition of a current of the secondary battery on the basis of the predicted transition of the temperature of the secondary battery, and estimate a remaining charge time or a remaining discharge time of the secondary battery on the basis of the predicted transition of the current of the secondary battery.

Advantages of the Invention

According to the present invention, the estimation accuracy of the remaining charge time or the remaining discharge time of the secondary battery can be increased.

Brief Description of the Drawings

FIG. 1 is a perspective view for illustrating a structure of an electrically driven excavator in a first embodiment of the present invention.
FIG. 2 is a block diagram for illustrating a configuration of a battery system in the first embodiment of the present invention.
FIG. 3 is a chart for illustrating a relation between the temperature and the resistance of a secondary battery in the first embodiment of the present invention.
FIG. 4 is a chart for illustrating a charge control characteristic in the first embodiment of the present invention.
FIG. 5 is a flowchart for illustrating processing of estimating a remaining charge time of the secondary battery in the first embodiment of the present invention.
FIG. 6A is a chart for illustrating a transition of the temperature of the secondary battery in the first embodiment of the present invention.
FIG. 6B is a chart for illustrating a transition of the voltage of the secondary battery in the first embodiment of the present invention.
FIG. 6C is a chart for illustrating a transition of the current of the secondary battery in the first embodiment of the present invention.
FIG. 7 is a chart for illustrating an effect of the first embodiment of the present invention.
FIG. 8 is a chart for illustrating a part of the transition of the current of the secondary battery in a modification example of the present invention.
FIG. 9 is a flowchart for illustrating the processing of estimating the remaining charge time of the secondary battery in a second embodiment of the present invention.
FIG. 10 is a chart for illustrating a discharge control characteristic in a third embodiment of the present invention.
FIG. 11 is a flowchart for illustrating processing of estimating a remaining discharge time of the secondary battery in the third embodiment of the present invention.
FIG. 12 is a flowchart for illustrating the processing of estimating the remaining discharge time of the secondary battery in a fourth embodiment of the present invention.

Modes for Carrying Out the Invention

An electrically driven excavator is exemplified as an application target of the present invention and a first embodiment of the present invention is described with reference to the drawings.

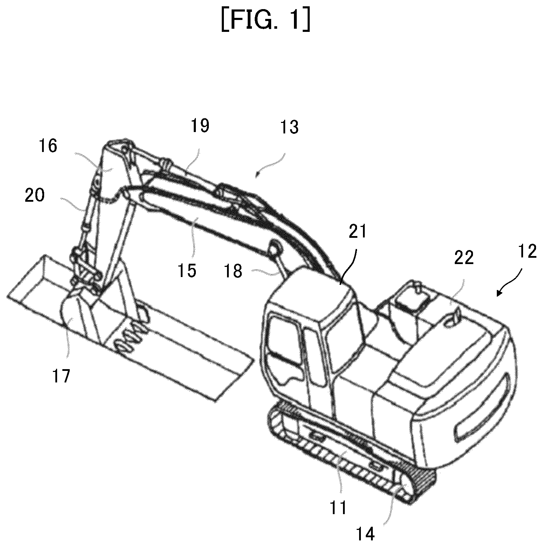

FIG. 1 is a perspective view for illustrating a structure of the electrically driven excavator in the present embodiment.
The electrically driven excavator according to the present embodiment includes a travel structure 11 which can travel, a swing structure 12 swingably provided on an upper side of the travel structure 11, and a work device 13 coupled to a front side of the swing structure 12. The travel structure 11 and the swing structure 12 configure a machine body. The travel structure 11 travels through rotation of left and right travel motors 14, and the swing structure 12 swings through rotation of a swing motor (not depicted).
The work device 13 is used to execute excavation work, loading work, and the like and is provided with a boom 15 rotatably coupled to a front portion of the swing structure 12, an arm 16 rotatably coupled to a distal end portion of the boom 15, and a bucket 17 rotatably coupled to a distal end portion of the arm 16. The boom 15 rotates through extension and contraction of a boom cylinder 18, the arm 16 rotates through extension and contraction of an arm cylinder 19, and the bucket 17 rotates through extension and contraction of a bucket cylinder 20.

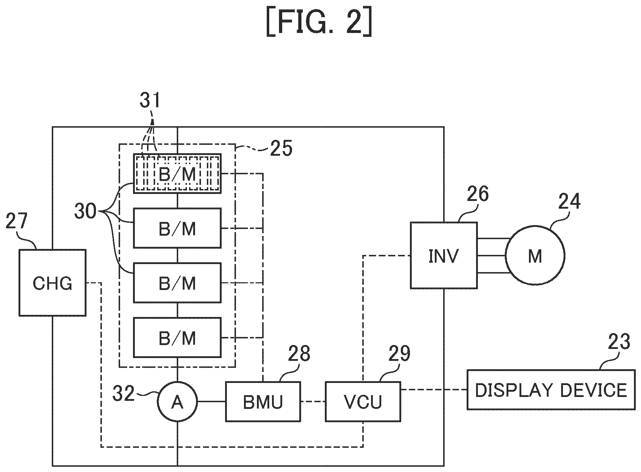

The swing structure 12 is provided with a cabin 21 in which an operator can board and a machine room 22 formed in a portion other than the cabin 21. To the cabin 21 of the swing structure 12, a plurality of operation levers (not depicted) operable by the operator and a display device 23 visually recognizable by the operator (In details, a display or the like. see FIG. 2 described later).

In the machine room 22 of the swing structure 12, there are provided an electrically driven motor 24 (see FIG. 2 described later), a hydraulic pump (not depicted) driven by the electrically driven motor 24, and a plurality of control valves (not depicted) which operate, in response to operations on the plurality of operation levers, and control flows (in details, the directions and the flow rates) of pressurized fluid from the hydraulic pump to the plurality of hydraulic actuators (in details, the travel motors 14, the swing motor, the boom cylinder 18, the arm cylinder 19, and the bucket cylinder 20 described before).

Moreover, in the machine room 22 of the swing structure 12, there is provided a battery system which supplies electric power to the electrically driven motor 24, thereby controlling the electrically driven motor 24. FIG. 2 is a diagram for illustrating a configuration of the battery system in the present embodiment.

The battery system according to the present embodiment is provided with a secondary battery (electricity storage device) 25 which stores electric power, an inverter 26 and a charger 27 connected to the secondary battery 25, a battery management unit (BMU) 28, and a vehicle control unit (VCU) 29.

The secondary battery 25 is configured by, for example, a plurality of battery modules 30 connected serially, and each battery module 30 is configured by a plurality of battery cells 31 (in details, lithium ion batteries, lead batteries, and the like) serially connected.

The battery management unit 28 is a microcontroller provided with a processing device and a storage device. The processing device executes processing according to a program and is a CPU (Central Processing Unit), an MPU (Micro Processing Unit), a DSP (Digital Signal Processor), or the like. The storage device stores programs and data and is a nonvolatile memory such as a ROM (Read Only Memory), a flash memory, and a hard disk drive or a volatile memory such as a RAM (Random Access Memory).

The battery management unit 28 detects a state of the secondary battery 25 described later and stores a detected history thereof. The battery management unit 28 uses a current sensor 32 to detect the current of the battery cells configuring the secondary battery 25, that is, the current of the secondary battery 25. The battery management unit 28 uses a plurality of temperature sensors (not depicted) to detect the temperatures of the plurality of battery cells configuring the secondary battery 25, thereby detecting the temperature of the secondary battery 25 being the average value or the minimum value of the battery cells. The battery management unit 28 uses a plurality of voltage sensors (not depicted) to detect the voltages of the plurality of battery cells configuring the secondary battery 25, thereby detecting the voltage of the secondary battery 25 being the sum of the battery cells. The battery management unit 28 uses a temperature sensor (not depicted) to detect the temperature of the external air.

The battery management unit 28 detects the state of charge (SOC) of the secondary battery 25 on the basis of the voltage of the secondary battery 25. In details, for example, when the battery management unit 28 or the like is switched from OFF to ON, the battery management unit 28 uses a map indicating a correspondence between the voltage of the secondary battery 25 and the state of charge of the secondary battery 25, thereby acquiring the state of charge of the secondary battery 25 from the voltage of the secondary battery 25 detected as described above. After that, the battery management unit 28 integrates the current of the secondary battery 25 detected as described above, computes a change amount of the state of charge of the secondary battery 25 on the basis of an integrated value thereof, and updates the state of charge of the secondary battery 25.

The battery management unit 28 detects the state of health quantity (SOHQ) of the secondary battery 25. In details, for example, the battery management unit 28 computes a difference between the state of charge for a previous time and the state of charge for a present time of the secondary battery 25 acquired through use of the map as described before and integrates the current of the secondary battery 25 detected in a period between the previous time and the present time. After that, the battery management unit 28 computes a present value of the capacity of the secondary battery 25 on the basis of a ratio between the difference in the state of charge and the integrated value of the current of the secondary battery 25. After that, the battery management unit 28 computes a ratio between the present value and the initial value of the capacity of the secondary battery 25, thereby acquiring the state of health quantity of the secondary battery 25.

The battery management unit 28 detects the state of health resistance (SOHR) of the secondary battery 25. In details, for example, the battery management unit 28 computes the resistance from the voltage and the current of the secondary battery 25 before a predetermined time has elapsed, computes the resistance from the voltage and the current of the secondary battery 25 after the predetermined time has elapsed, and acquires a present value of a change amount of the resistance of the secondary battery 25 being a difference therebetween. After that, the battery management unit 28 computes a ratio between the present value and an initial value of the change amount of the resistance of the secondary battery 25, thereby acquiring the state of health resistance of the secondary battery **25.**

The vehicle control unit 29 is a microcontroller provided with a processing device and a storage device. The processing device executes processing according to a program and is a CPU, an MPU, a DSP, or the like. The storage device stores programs and data and is a nonvolatile memory such as a ROM, a flash memory, and a hard disk drive or a volatile memory such as a RAM.

The vehicle control unit 29 outputs a command of causing the electrically driven motor 24 to drive (in other words, a command of discharging the secondary battery 25) to the inverter 26. The inverter 26 inverts, according to the command described above, DC power of the secondary battery 25 to AC power and supplies the AC power to the electrically driven motor 24, thereby causing the electrically driven motor 24 to drive.

The vehicle control unit 29 outputs, to the charger 27, a command of charging the secondary battery 25 through, for example, a constant current charge method. The charger 27 uses electric power supplied from an external power supply (not depicted) to charge the secondary battery 25.

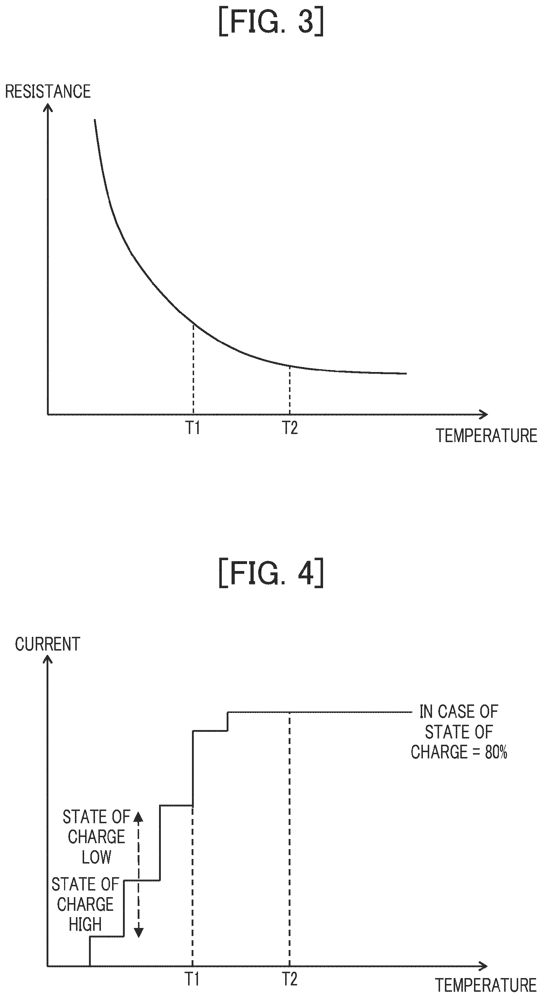

At the time of the charge of the secondary battery 25, as the charge time elapses, the temperature of the secondary battery 25 increases. As illustrated in FIG. 3, the resistance of the secondary battery 25 is high when the temperature of the secondary battery 25 is low compared with that when the temperature of the secondary battery 25 is high, hence the change amount of the voltage of the secondary battery 25 tends to be large, and deterioration likely progresses. Thus, in consideration of suppression of the deterioration of the secondary battery 25, it is preferred that the current of the secondary battery 25 be small. Meanwhile, when the temperature of the secondary battery 25 is high, in consideration of a reduction in charge time of the secondary battery 25, it is preferred that the current of the secondary battery 25 be large. Thus, as illustrated in FIG. 4, the vehicle control unit 29 outputs, to the charger 27, a command of stepwise changing the current of the secondary battery 25 according to the temperature of the secondary battery 25 detected by the battery management unit 28. In details, the vehicle control unit 29 outputs, to the charger 27, a command of stepwise increasing the current of the secondary battery 25 according to the increase in temperature of the secondary battery 25 increases.

The vehicle control unit 29 manages the charge and discharge of the secondary battery 25. The vehicle control unit 29 outputs, to the charger 27, a command of stepwise changing the current of the secondary battery 25 according to the state of charge (or the voltage) of the secondary battery 25 detected by the battery management unit 28. In details, the vehicle control unit 29 outputs, to the charger 27, a command of stepwise reducing the current of the secondary battery 25 according to the increase in the state of charge (or the voltage) of the secondary battery 25.

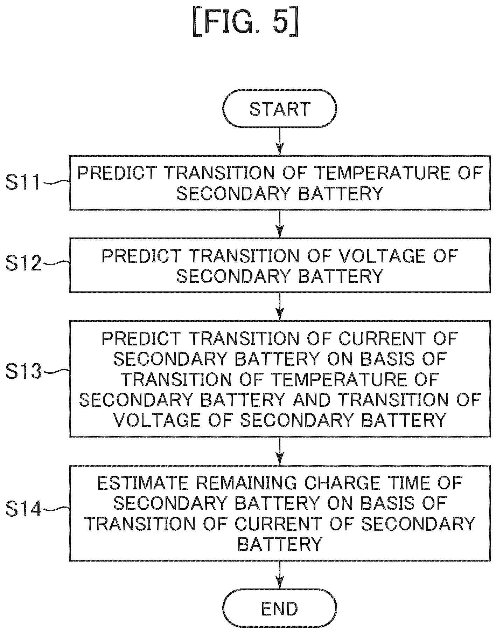

As a characteristic of the present embodiment, the vehicle control unit 29 estimates a remaining charge time of the secondary battery 25 when the secondary battery 25 is charged and causes the remaining charge time to be displayed on the display device 23. With reference to FIG. 5, a description is now given of processing of estimating the remaining charge time of the secondary battery 25 in the present embodiment. FIG. 5 is a flowchart for illustrating the processing of estimating the remaining charge time of the secondary battery in the present embodiment.

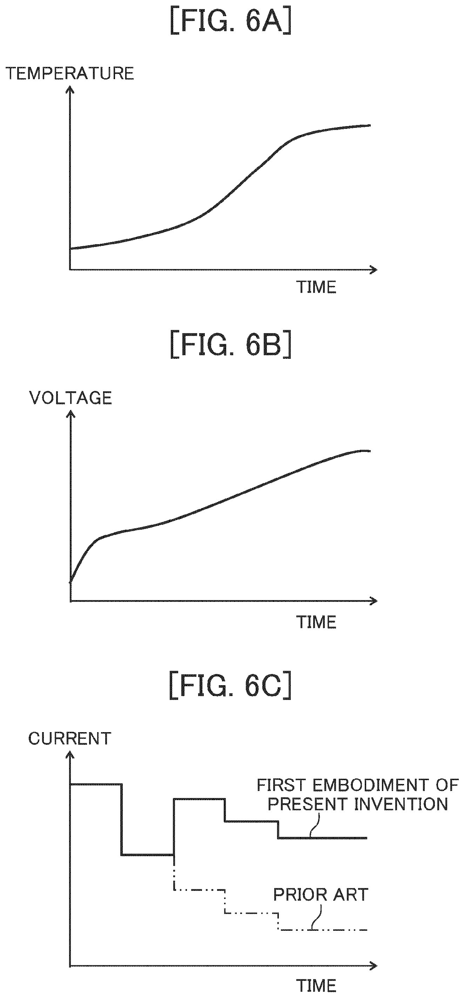

In Step S11, the vehicle control unit 29 predicts a transition (see FIG. 6A) of the temperature of the secondary battery 25 on the basis of the temperature and the state of charge of the secondary battery 25 detected by the battery management unit 28. In details, the vehicle control unit 25 stores, for example, data on the transition of the temperature of the secondary battery 25 acquired in advance for each condition formed of the temperature and the state of charge of the secondary battery 25 at a charge start time of the secondary battery 25 and extracts the data on the transition of the temperature of the secondary battery 25 corresponding to the temperature and the state of charge of the secondary battery 25 detected at the charge start time of the secondary battery 25. The following Table 1 indicates the data on the transition of the temperature of the secondary battery 25 in a case in which the temperature of the secondary battery 25 is 0°C and the state of charge thereof is 20% at the charge start time of the secondary battery 25. In Table 1, for the convenience of description, a case in which the time interval is 10 minutes is exemplified, but the time interval is not limited to this example.

[TABLE 1]

| Elapsed time [min] | 0 | 10 | 20 | 30 | 40 | 50 |
|---|---|---|---|---|---|---|
| Temperature [°C] | 0 | 10 | 18 | 23 | 26 | 28 |

In Step S12, the vehicle control unit 29 predicts a transition (see FIG. 6B) of the voltage of the secondary battery 25 on the basis of the temperature and the state of charge of the secondary battery 25 detected by the battery management unit 28. In details, the vehicle control unit 29 stores, for example, data on the transition of the voltage of the secondary battery 25 acquired in advance for each condition formed of the temperature and the state of charge of the secondary battery 25 at the charge start time of the secondary battery 25 and extracts the data on the transition of the voltage of the secondary battery 25 corresponding to the temperature and the state of charge of the secondary battery 25 detected at the charge start time of the secondary battery 25. Table 2 indicates the data on the transition of the voltage of the secondary battery 25 in a case in which the temperature of the secondary battery 25 is 0°C and the state of charge thereof is 20% at the charge start time of the secondary battery 25. In Table 2, for the convenience of description, a case in which the time interval is 10 minutes is exemplified, but the time interval is not limited to this example.

[TABLE 2]

| Elapsed time [min] | 0 | 10 | 20 | 30 | 40 | 50 |
|---|---|---|---|---|---|---|
| VOLTAGE [V] | 320 | 335 | 345 | 360 | 370 | 375 |

The vehicle control unit 29 proceeds to Step S13 and predicts the transition (see a solid line of FIG. 6C) of the current of the secondary battery 25 on the basis of the transition of the temperature of the secondary battery 25 predicted in Step S11 and the transition of the voltage of the secondary battery 25 predicted in Step S12. In details, the vehicle control unit 29 uses the charge control characteristic described with reference to FIG. 4 to predict the transition of the current of the secondary battery 25.

The vehicle control unit 29 proceeds to Step S14 and estimates the remaining charge time of the secondary battery 25 on the basis of the transition of the current of the secondary battery 25 predicted in Step S13. In details, the vehicle control unit 29 again computes the transition of the voltage of the secondary battery 25 on the basis of the transition of the current of the secondary battery 25. Moreover, in the present embodiment, for the secondary battery 25 being charged through the constant current charge method, the vehicle control unit 29 computes, as the remaining charge time, a time until, for example, the voltage of the secondary battery 25 becomes equal to or higher than a set value. As another example, the vehicle control unit 29 computes a transition of the state of charge of the secondary battery 25 on the basis of the transition of the current of the secondary battery 25 and computes, as the remaining charge time, a time until, for example, the state of charge of the secondary battery 25 reaches a set value.

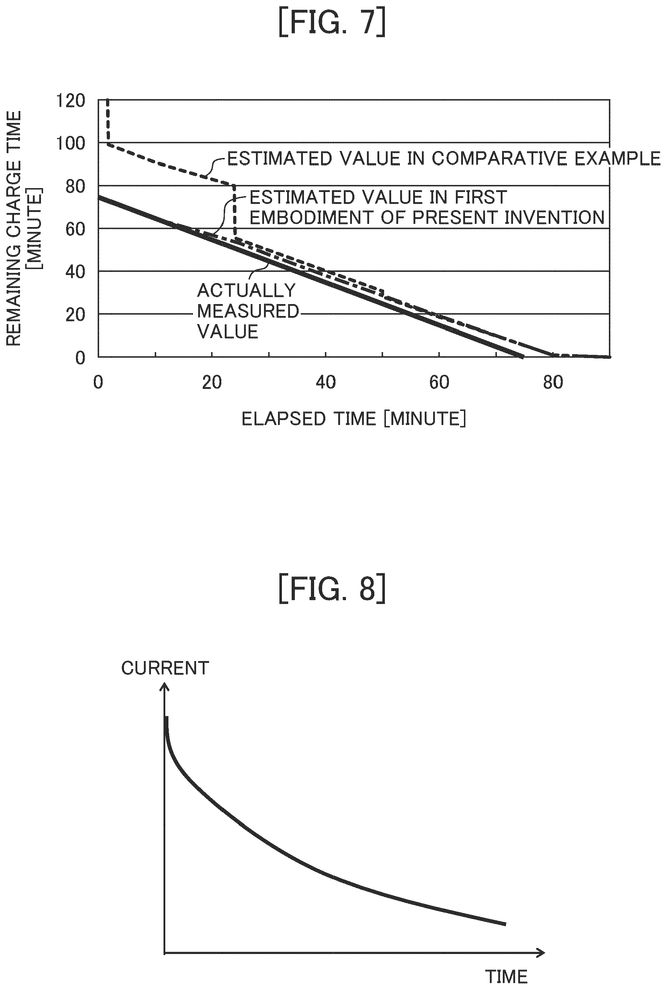

As described above, in the present embodiment, the transitions of the temperature and the like of the secondary battery 25 are predicted, the transition of the current of the secondary battery 25 is predicted on the basis of the transitions of the temperature and the like of the secondary battery 25, and the remaining charge time of the secondary battery 25 is estimated on the basis of the transition of the current of the secondary battery 25. Thus, as illustrated in FIG. 7, compared with a case (comparative example) in which the remaining charge time of the secondary battery 25 is estimated from only the present temperature of the secondary battery 25 without considering the change in temperature of the secondary battery 25, it is possible to reduce an error (a difference from an actually measured value) of the estimated value of the remaining charge time of the secondary battery 25. That is, estimation accuracy of the remaining charge time of the secondary battery 25 can be increased.

Note that there is exemplified the case in which the vehicle control unit 29 predicts the transition of the temperature of the secondary battery 25 on the basis of the temperature and the state of charge of the secondary battery 25 detected by the battery management unit 28 in the first embodiment, but the configuration is not limited to this example. The vehicle control unit 29 may predict the transition of the temperature of the secondary battery 25 on the basis of the temperature and the voltage of the secondary battery 25 detected by the battery management unit 28. In details, the vehicle control unit 25 may store, for example, data on the transition of the temperature of the secondary battery 25 acquired in advance for each condition formed of the temperature and the voltage of the secondary battery 25 at the charge start time of the secondary battery 25 and may extract the data on the transition of the temperature of the secondary battery 25 corresponding to the temperature and the voltage of the secondary battery 25 at the charge start time of the secondary battery 25 detected by the battery management unit 28.

As another example, the vehicle control unit 29 may predict the transition of the temperature of the secondary battery 25 on the basis of the temperature, the state of charge or the voltage, and the state of health of the secondary battery 25 detected by the battery management unit 28. In details, the vehicle control unit 25 may store, for example, data on the transition of the temperature of the secondary battery 25 acquired in advance for each condition formed of the temperature, the state of charge or the voltage, and the state of health (in details, the state of health quantity and/or the state of health resistance) of the secondary battery 25 at the charge start time of the secondary battery 25 and may extract the data on the transition of the temperature of the secondary battery 25 corresponding to the temperature, the state of charge or the voltage, and the state of health (in details, the state of health quantity and/or the state of health resistance) of the secondary battery 25 detected at the charge start time of the secondary battery 25 by the battery management unit 28.

Moreover, there is exemplified the case in which the vehicle control unit 29 predicts the transition of the voltage of the secondary battery 25 on the basis of the temperature and the state of charge of the secondary battery 25 detected by the battery management unit 28 in the first embodiment, but the configuration is not limited to this example. The vehicle control unit 29 may predict the transition of the voltage of the secondary battery 25 on the basis of the temperature and the voltage of the secondary battery 25 detected by the battery management unit 28. In details, the vehicle control unit 25 may store, for example, data on the transition of the voltage of the secondary battery 25 acquired in advance for each condition formed of the temperature and the voltage of the secondary battery 25 at the charge start time of the secondary battery 25 and may extract the data on the transition of the voltage of the secondary battery 25 corresponding to the temperature and the voltage of the secondary battery 25 detected at the charge start time of the secondary battery 25 by the battery management unit 28.

As another example, the vehicle control unit 29 may predict the transition of the voltage of the secondary battery 25 on the basis of the temperature, the state of charge (or the voltage), and the state of health of the secondary battery 25 detected by the battery management unit 28. In details, the vehicle control unit 25 may store, for example, data on the transition of the voltage of the secondary battery 25 acquired in advance for each condition formed of the temperature, the state of charge (or the voltage), and the state of health (in details, the state of health quantity and/or the state of health resistance) of the secondary battery 25 at the charge start time of the secondary battery 25 and may extract the data on the transition of the voltage of the secondary battery 25 corresponding to the temperature, the state of charge (or the voltage), and the state of health (in details, the state of health quantity and/or the state of health resistance) of the secondary battery 25 detected at the charge start time of the secondary battery 25 by the battery management unit 28.

Moreover, there is exemplified the case in which the vehicle control unit 29 predicts the transition of the temperature and the transition of the voltage of the secondary battery 25 and predicts the transition of the current of the secondary battery 25 on the basis of the transition of the temperature and the transition of the voltage of the secondary battery 25 in the first embodiment, but the configuration is not limited to this example. The vehicle control unit 29 may estimate, in place of the transition of the voltage of the secondary battery 25, the transition of the state of charge of the secondary battery 25 and may predict the transition of the current of the secondary battery 25 on the basis of the transition of the temperature and the transition of the state of charge of the secondary battery 25.

Moreover, there is exemplified the case in which the vehicle control unit 29 stepwise changes the current of the secondary battery 25 according to the state of charge (or the voltage) of the secondary battery 25 detected by the battery management unit 28 at the time of the charge of the secondary battery 25 in the first embodiment, but the configuration is not limited to this example. The vehicle control unit 29 may not change the current of the secondary battery 25 according to the state of charge (or the voltage) of the secondary battery 25 detected by the battery management unit 28 at the charge time of the secondary battery 25. In this modification example, the vehicle control unit 29 is not required to predict the transition of the voltage (or the state of charge) of the secondary battery 25 and is only required to predict the transition of the current of the secondary battery 25 on the basis of the transition of the temperature of the secondary battery 25.

Moreover, there is exemplified the case in which the secondary battery 25 is charged through the constant current charge method in the first embodiment, but the configuration is not limited to this example. The secondary battery 25 may be charged through a constant current / constant voltage charge method (in details, a method in which a constant current charge step is executed and then a constant voltage charge step is executed when, for example, the voltage of the secondary battery 25 reaches a predetermined value). In this modification example, the transition of the current of the secondary battery 25 in the constant current charge step is as illustrated as a solid line of FIG. 6C described above. The current of the secondary battery 25 in the constant voltage charge step decreases as the constant voltage charge time elapses as illustrated in FIG. 8. The vehicle control unit 29 uses, for example, a mathematical model to predict the transition of the current of the secondary battery 25 in the constant voltage charge step. As another example, the vehicle control unit 29 uses, for example, a transition of a decrease rate of the current acquired in advance to predict the transition of the current of the secondary battery 25 in the constant voltage charge step. Further, the transition of the current of the secondary battery 25 in the constant voltage charge step may be corrected on the basis of the temperature or the state of health of the secondary battery 25.

In the modification examples described above, for the secondary battery 25 being charged through the constant current / constant voltage charge method, the vehicle control unit 29, in Step S14 of FIG. 5, computes, for example, as a constant current charge time, a time until the voltage of the secondary battery 25 reaches the predetermined value in the constant current charge step and computes, as a constant voltage charge time, a time until the current of the secondary battery 25 becomes smaller than a set value in the constant voltage charge step, and computes a total charge time being a sum thereof. After that, the vehicle control unit 29 subtracts a time which has elapsed since the charge start of the secondary battery 25 from the total charge time, thereby computing the remaining charge time.

A description is now given of a second embodiment of the present invention. Note that portions in the present embodiment that are equivalent to their counterparts in the first embodiment are given the same reference characters and a description thereof is omitted as appropriate.

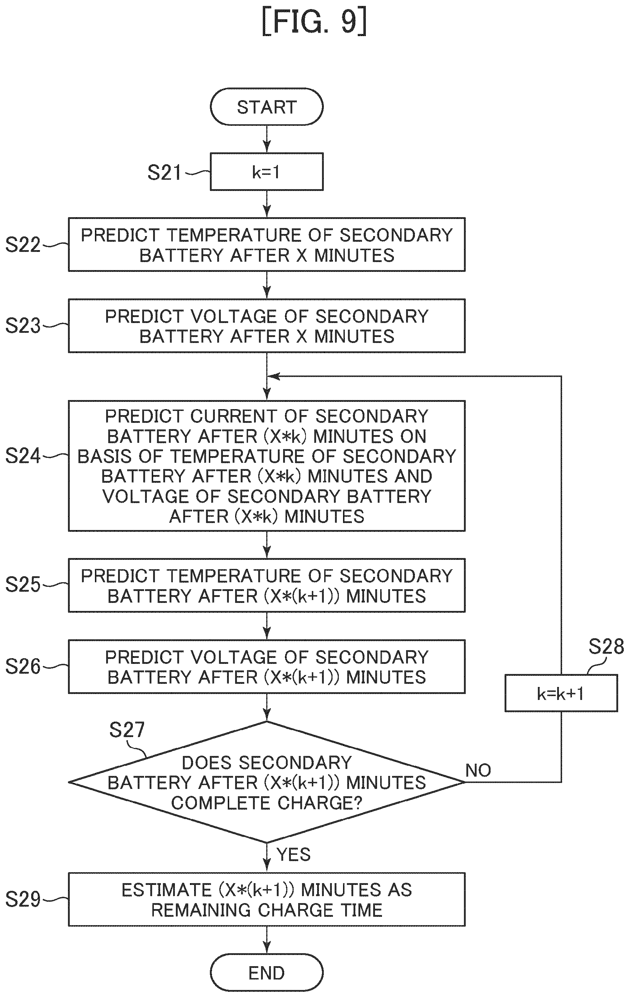

The vehicle control unit 29 according to the present embodiment estimates the remaining charge time of the secondary battery 25 at the charge time of the secondary battery 25 and causes the remaining charge time to be displayed on the display device 23, but the estimation method thereof is different from that in the first embodiment. With reference to FIG. 9, a description is now given of processing of estimating the remaining charge time of the secondary battery 25 in the present embodiment. FIG. 9 is a flowchart for illustrating the processing of estimating the remaining charge time of the secondary battery in the present embodiment.

In Step S21, the vehicle control unit 29 initializes an operator k to 1. The vehicle control unit 29 proceeds to Step S22 and uses a heat balance model to predict the temperature of the secondary battery 25 after X minutes. As given by Expression (1), the heat balance of the secondary battery 25 is expressed through use of generated heat Qb, radiant heat Qr, a surface area S, and a temperature T of the secondary battery 25, a temperature Tm of an external air (cooling medium) which cools the secondary battery 25, and a heat transfer coefficient α. The radiant heat Qr and the surface area S of the secondary battery 25 are fixed values. The heat transfer coefficient α is a fixed value, but may be changed according to a change in cooling method such as natural cooling and forced cooling. As given by Expression (2), the generated heat Qb of the secondary battery is obtained through use of a resistance (in details, a value corresponding to a difference between the voltage V and an open circuit voltage OCV) and a current I of the secondary battery 25. The open circuit voltage OCV is a fixed value. As given by Expression (3), an increase amount ΔT of the temperature of the secondary battery 25 is obtained through use of heat Q and a heat capacity C of the secondary battery 25. The heat capacity C is a fixed value. Thus, the vehicle control unit 29 uses Expressions (1) to (3) to predict the temperature of the secondary battery 25 after X minutes on the basis of the present temperature, voltage, and current of the secondary battery 25, and the temperature of the external air detected by the battery management unit 28.

[EXPRESSION 1]

$$Q = Q_b - Q_r - \alpha \times S \times (T - T_m) \quad \cdot \cdot \cdot \quad (1)$$

[EXPRESSION 2]

$$Q_b = (V - OCV) \times I \quad \cdot \cdot \cdot \quad (2)$$

[EXPRESSION 3]

$$\Delta T = \frac{Q}{C} \quad \cdot \cdot \cdot \quad (3)$$

In Step S23, the vehicle control unit 29 uses an electric circuit model to predict the voltage of the secondary battery 25 after X minutes. As given by Expression (4), the voltage V of the secondary battery 25 is obtained through use of the open circuit voltage OCV, the current I, an instantaneous resistance Ro, the state of health resistance SOHR, and a polarization voltage Vp of the secondary battery **25.** The instantaneous resistance Ro is obtained through use of the state of charge SOC and the temperature T. As given by Expression (5), the polarization voltage Vp is obtained through use of the current I, a polarization resistance Rp, an elapsed time t, and a time constant τ. The polarization resistance Rp is obtained through use of the state of charge SOC and the temperature T. The time constant τ is a fixed value. Thus, the vehicle control unit 29 uses Expressions (4) and (5) to predict the voltage of the secondary battery 25 after X minutes on the basis of the present temperature, state of charge, state of health resistance, and current of the secondary battery 25 detected by the battery management unit 28.

[EXPRESSION 4]

$$V = OCV + I \times R_o(SOC, T) \times SOHR + Vp(SOC, T) \quad \cdot \cdot \cdot \quad (4)$$

[EXPRESSION 5]

$$Vp = I \times Rp(SOC, T) \times SOHR \times \left(1 - \exp\left(\frac{t}{\tau}\right)\right) \quad \cdot \cdot \cdot \quad (5)$$

The vehicle control unit 29 proceeds to Step S24, the operator k is 1, hence the vehicle control unit 29 predicts the current of the secondary battery 25 after X minutes on the basis of the temperature of the secondary battery 25 after X minutes predicted in Step S22 and the voltage of the secondary battery 25 after X minutes predicted in Step S23. In details, the vehicle control unit 29 uses the charge control characteristic described with reference to FIG. 4 to predict the current of the secondary battery 25 after X minutes. Note that the predicted current of the secondary battery 25 is set to a current equal to or smaller than the present current of the secondary battery 25 detected by the battery management unit 28.

The vehicle control unit 29 proceeds to Step S25, the operator k is 1, and hence the vehicle control unit 29 uses the heat balance model to predict the temperature of the secondary battery 25 after (X×2) minutes. In details, the vehicle control unit 29 uses Expressions (1) to (3) to predict the temperature of the secondary battery 25 after (X×2) minutes on the basis of the temperature, the voltage, and the current of the secondary battery 25, and the temperature of the external air after X minutes. Note that it is assumed that the temperature of the external air after X minutes is the same as the present temperature of the external air.

In Step S26, the operator k is 1, and hence the vehicle control unit 29 uses the electric circuit model to predict the voltage of the secondary battery 25 after ($X\times2$) minutes. In details, the vehicle control unit 29 uses Expressions (4) and (5) to predict the voltage of the secondary battery 25 after ($X\times2$) minutes on the basis of the temperature, the state of charge, the state of health resistance, and the current of the secondary battery 25 after X minutes. Note that the state of charge of the secondary battery 25 after X minutes is obtained through use of the present state of charge and current of the secondary battery 25. It is assumed that the state of health resistance of the secondary battery 25 after X minutes is the same as the present state of health resistance of the secondary battery 25.

The vehicle control unit 29 proceeds to Step S27 and determines whether the secondary battery 25 after ($X\times2$) minutes completes the charge. In a case in which the secondary battery 25 is charged through the constant current charge method, the vehicle control unit 29 determines whether the secondary battery 25 completes the charge according to, for example, whether the voltage of the secondary battery 25 is equal to or higher than the set value. In a case in which the secondary battery 25 is charged through the constant current / constant voltage charge method, the vehicle control unit 29 determines whether the secondary battery 25 completes the charge according to, for example, whether the current of the secondary battery 25 is smaller than the set value in the constant voltage charge step. When the secondary battery 25 after ($X\times2$) minutes does not complete the charge, the vehicle control unit 29 proceeds to Step S28.

In Step S28, the vehicle control unit 29 updates the operator k to 2. The vehicle control unit 29 proceeds to Step S24, the operator k is 2, and hence the vehicle control unit 29 predicts the current of the secondary battery 25 after ($X\times2$) minutes on the basis of the temperature of the secondary battery 25 after ($X\times2$) minutes and the voltage of the secondary battery 25 after ($X\times2$) minutes. The vehicle control unit 29 proceeds to Step S25, the operator k is 2, and hence the vehicle control unit 29 predicts the temperature of the secondary battery 25 after ($X\times3$) minutes on the basis of the temperature, the voltage, and the current of the secondary battery 25, and the temperature of the external air after ($X\times2$) minutes. In Step S26, the operator k is 2, and hence the vehicle control unit 29 predicts the voltage of the secondary battery 25 after ($X\times3$) minutes on the basis of the temperature, the state of charge, the state of health resistance, and the current of the secondary battery 25 after ($X\times2$) minutes. The vehicle control unit 29 proceeds to Step S27 and determines whether the secondary battery 25 after ($X\times3$) minutes completes the charge.

Until the vehicle control unit 29 determines that the secondary battery 25 after ($X\times k$) minutes completes the charge in Step S27, the vehicle control unit 29 updates the operator k in Step S28 and repeats Steps S24, S25, and S26. When the vehicle control unit 29 determines that the secondary battery 25 after ($X\times k$) minutes completes the charge, the vehicle control unit 29 proceeds to Step S29. In Step S29, the vehicle control unit 29 estimates that the remaining charge time of the secondary battery 25 is ($X\times k$) minutes.

Also, in the present embodiment described above, compared with the case in which the remaining charge time of the secondary battery 25 is estimated from only the present temperature of the secondary battery 25 without considering the change in temperature of the secondary battery 25, it is possible to increase the estimation accuracy of the remaining charge time of the secondary battery 25.

Moreover, in the present embodiment, the heat balance model and the electric circuit model (in details, Expressions (1) to (5) described before) are used, and hence, compared with the case in which the data on the secondary battery 25 obtained in advance for each condition of the secondary battery 25 is used as in the first embodiment, a load imposed by preparation thereof can be reduced. Moreover, compared with the first embodiment, the estimation accuracy of the remaining charge time of the secondary battery 25 can be increased.

A description is now given of a third embodiment of the present invention. Note that portions in the present embodiment that are equivalent to their counterparts in the first embodiment are given the same reference characters and a description thereof is omitted as appropriate.

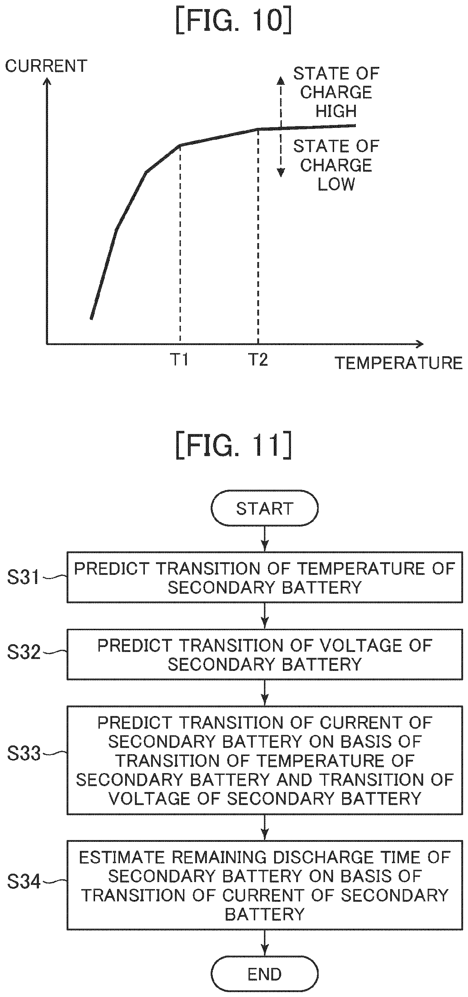

At the discharge time of the secondary battery 25, as the discharge time elapses, the temperature of the secondary battery 25 increases. As illustrated in FIG. 3, since the resistance of the secondary battery 25 when the temperature of the secondary battery 25 is low is high compared with that when the temperature of the secondary battery 25 is high, a change amount of the voltage of the secondary battery 25 tends to be large, and hence the deterioration likely progresses. Thus, in consideration of the suppression of the deterioration of the secondary battery 25, it is preferred that the current of the secondary battery 25 is small. Meanwhile, when the temperature of the secondary battery 25 is high, it is preferred that the current of the secondary battery 25 be large in consideration of an increase in power of the electrically driven motor 24. Thus, the vehicle control unit 29 according to the present embodiment outputs, to the inverter 26, a command of changing the current of the secondary battery 25 according to the temperature of the secondary battery 25 detected by the battery management unit 28 as illustrated in FIG. 10. In details, the vehicle control unit 29 outputs, to the inverter 26, a command of increasing the current of the secondary battery 25 according to the increase in the temperature of the secondary battery **25.**

The vehicle control unit 29 outputs, to the inverter 26, a command of changing the current of the secondary battery 25 according to the state of charge (or the voltage) of the secondary battery 25 detected by the battery management unit **28.** In details, the vehicle control unit 29 outputs, to the inverter 26, a command of reducing the current of the secondary battery 25 according to the decrease in the state of charge (or the voltage) of the secondary battery **25.**

As a characteristic of the present embodiment, the vehicle control unit 29 estimates the remaining discharge time of the secondary battery 25 (in other words, a remaining operation time of the electrically driven excavator) at the time of the discharge of the secondary battery 25 and causes the estimated remaining discharge time to be displayed on the display device 23. With reference to FIG. 11, a description is now given of processing of estimating the remaining discharge time of the secondary battery 25 in the present embodiment. FIG. 11 is a flowchart for illustrating the processing of estimating the remaining discharge time of the secondary battery in the present embodiment.

In Step S31, the vehicle control unit 29 predicts the transition of the temperature of the secondary battery 25 on the basis of the temperature and the state of charge of the secondary battery 25 detected by the battery management unit 28. In details, the vehicle control unit 25 stores, for example, data on the transition of the temperature of the secondary battery 25 acquired in advance for each condition formed of the temperature and the state of charge of the secondary battery 25 at a start of the discharge of the secondary battery 25 and extracts the data on the transition of the temperature of the secondary battery 25 corresponding to the temperature and the state of charge of the secondary battery 25 detected at the discharge start time of the secondary battery 25.

In Step S32, the vehicle control unit 29 predicts the transition of the voltage of the secondary battery 25 on the basis of the temperature and the state of charge of the secondary battery 25 detected by the battery management unit 28. In details, the vehicle control unit 25 stores, for example, data on the transition of the voltage of the secondary battery 25 acquired in advance for each condition formed of the temperature and the state of charge of the secondary battery 25 at the discharge start time of the secondary battery 25 and extracts the data on the transition of the voltage of the secondary battery 25 corresponding to the temperature and the state of charge of the secondary battery 25 detected at the charge start time of the secondary battery 25.

The vehicle control unit 29 proceeds to Step S33 and predicts the transition of the current of the secondary battery 25 on the basis of the transition of the temperature of the secondary battery 25 predicted in Step S31 and the transition of the voltage of the secondary battery 25 predicted in Step S32. In details, the vehicle control unit 29 uses the discharge control characteristic described with reference to FIG. 10 to predict the transition of the current of the secondary battery 25.

The vehicle control unit 29 proceeds to Step S34 and estimates the remaining discharge time of the secondary battery 25 on the basis of the transition of the current of the secondary battery 25 predicted in Step S33. In details, the vehicle control unit 29 again computes the transition of the voltage of the secondary battery 25 on the basis of the transition of the current of the secondary battery 25. After that, the vehicle control unit 29 computes, as the remaining discharge time, a time until, for example, the voltage of the secondary battery 25 becomes lower than a set value. As another example, the vehicle control unit 29 computes a transition of the state of charge of the secondary battery 25 on the basis of the transition of the current of the secondary battery 25 and computes, as the remaining discharge time, a time until, for example, the state of charge of the secondary battery 25 becomes smaller than a set value.

As described above, in the present embodiment, the transitions of the temperature and the like of the secondary battery 25 are predicted, the transition of the current of the secondary battery 25 is predicted on the basis of the transitions of the temperature and the like of the secondary battery 25, and the remaining discharge time of the secondary battery 25 is estimated on the basis the transition of the current of the secondary battery 25. Thus, compared with the case in which the remaining discharge time of the secondary battery 25 is estimated from only the present temperature of the secondary battery 25 without considering the change in temperature of the secondary battery 25, it is possible to increase the estimation accuracy of the remaining discharge time of the secondary battery 25.

Note that the third embodiment may be modified as the modification examples made to the first embodiment described before. Further, a discharge situation of the secondary battery 25 changes according to a drive situation of the electrically driven motor 24 and hence the current of the secondary battery 25 may be added as a parameter. That is, the vehicle control unit 29 may predict, on the basis of the temperature, the state of charge or the voltage, and the current (or an average current in a predetermined time) of the secondary battery 25 detected by the battery management unit 28, the transition of the temperature of the secondary battery 25 and the transition of the voltage or the state of charge of the secondary battery 25. Moreover, the vehicle control unit 29 may predict, on the basis of the temperature, the state of charge or the voltage, the state of health, and the current (or an average current in a predetermined time) of the secondary battery 25 detected by the battery management unit 28, the transition of the temperature of the secondary battery 25 and the transition of the voltage or the state of charge of the secondary battery 25.

A description is now given of a fourth embodiment of the present invention. Note that portions in the present embodiment that are equivalent to their counterparts in the third embodiment are given the same reference characters and a description thereof is omitted as appropriate.

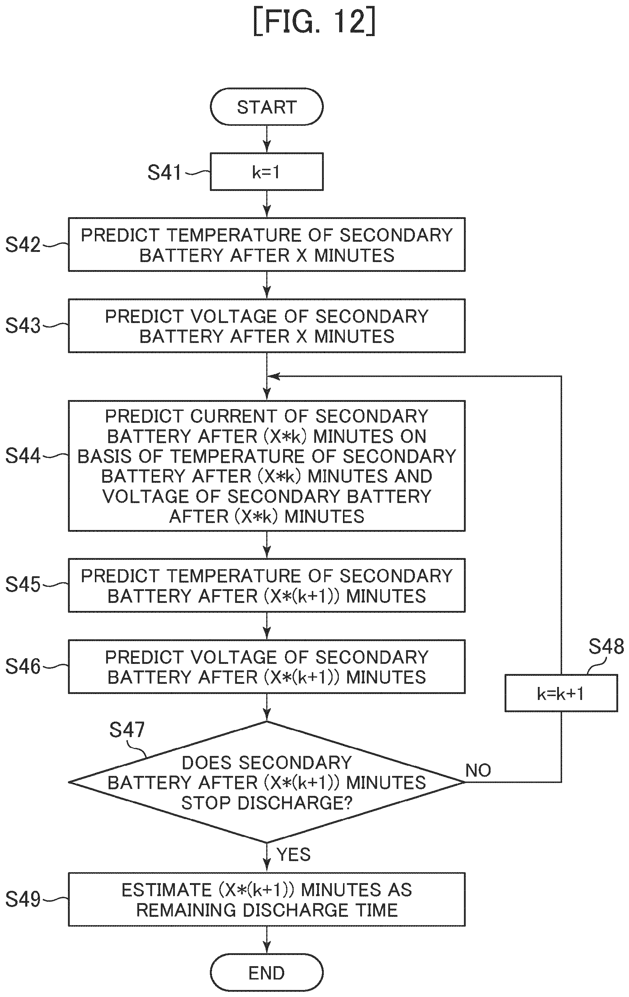

The vehicle control unit 29 according to the present embodiment estimates the remaining discharge time of the secondary battery 25 at the discharge time of the secondary battery 25 and causes the remaining discharge time to be displayed on the display device 23, but the estimation method thereof is different from that in the third embodiment. With reference to FIG. 12, a description is now given of processing of estimating the remaining discharge time of the secondary battery 25 in the present embodiment. FIG. 12 is a flowchart for illustrating the processing of estimating the remaining discharge time of the secondary battery in the present embodiment.

In Step S41, the vehicle control unit 29 initializes the operator k to 1. The vehicle control unit 29 proceeds to Step S42 and uses the heat balance model to predict the temperature of the secondary battery 25 after X minutes. In details, the vehicle control unit 29 uses Expressions (1) to (3) to predict the temperature of the secondary battery 25 after X minutes on the basis of the present temperature, voltage, and current of the secondary battery 25, and the temperature of the external air detected by the battery management unit 28.

In Step S43, the vehicle control unit 29 uses the electric circuit model to predict the voltage of the secondary battery 25 after X minutes. In details, the vehicle control unit 29 uses Expressions (4) and (5) to predict the voltage of the secondary battery 25 after X minutes on the basis of the present temperature, state of charge, state of health resistance, and current of the secondary battery 25 detected by the battery management unit 28.

The vehicle control unit 29 proceeds to Step S44, the operator k is 1, hence the vehicle control unit 29 predicts the current of the secondary battery 25 after X minutes on the basis of the temperature of the secondary battery 25 after X minutes predicted in Step S42 and the voltage of the secondary battery 25 after X minutes predicted in Step S43. In details, the vehicle control unit 29 uses the discharge control characteristic described with reference to FIG. 10 to predict the current of the secondary battery 25 after X minutes.

The vehicle control unit 29 proceeds to Step S45, the operator k is 1, and hence the vehicle control unit 29 uses the heat balance model to predict the temperature of the secondary battery 25 after $(X \times 2)$ minutes. In details, the vehicle control unit 29 uses Expressions (1) to (3) to predict the temperature of the secondary battery 25 after $(X \times 2)$ minutes on the basis of the temperature, the voltage, and the current of the secondary battery 25, and the temperature of the external air after X minutes.

In Step S46, the operator k is 1, and hence the vehicle control unit 29 uses the electric circuit model to predict the voltage of the secondary battery 25 after $(X \times 2)$ minutes. In details, the vehicle control unit 29 uses Expressions (4) and (5) to predict the voltage of the secondary battery 25 after $(X \times 2)$ minutes on the basis of the temperature, the state of charge, the state of health resistance, and the current of the secondary battery 25 after X minutes.

The vehicle control unit 29 proceeds to Step S47 and determines whether the secondary battery 25 after $(X \times 2)$ minutes stops the discharge. In details, the vehicle control unit 29 determines whether the secondary battery 25 stops the discharge according to whether, for example, the voltage of the secondary battery 25 is lower than the set value. When the secondary battery 25 after $(X \times 2)$ minutes does not stop the discharge, the vehicle control unit 29 proceeds to Step S48.

In Step S48, the vehicle control unit 29 updates the operator k to 2. The vehicle control unit 29 proceeds to Step S44, the operator k is 2, and hence the vehicle control unit 29 predicts the current of the secondary battery 25 after $(X \times 2)$ minutes on the basis of the temperature of the secondary battery 25 after $(X \times 2)$ minutes and the voltage of the secondary battery 25 after $(X \times 2)$ minutes. The vehicle control unit 29 proceeds to Step S45, the operator k is 2, and hence the vehicle control unit 29 predicts the temperature of the secondary battery 25 after $(X \times 3)$ minutes on the basis of the temperature, the voltage, and the current of the secondary battery 25, and the temperature of the external air after $(X \times 2)$ minutes. In Step S46, the operator k is 2, and hence the vehicle control unit 29 predicts the voltage of the secondary battery 25 after $(X \times 3)$ minutes on the basis of the temperature, the state of charge, the state of health resistance, and the current of the secondary battery 25 after $(X \times 2)$ minutes. The vehicle control unit 29 proceeds to Step S47 and determines whether the secondary battery 25 after $(X \times 3)$ minutes stops the discharge.

Until the vehicle control unit 29 determines that the secondary battery 25 after $(X \times k)$ minutes stops the discharge in Step S47, the vehicle control unit 29 updates the operator k in Step S48 and repeats Steps S44, S45, and S46. When the vehicle control unit 29 determines that the secondary battery 25 after $(X \times k)$ minutes stops the discharge, the vehicle control unit 29 proceeds to Step S49. In Step S49, the vehicle control unit 29 estimates that the remaining discharge time of the secondary battery 25 is $(X \times k)$ minutes.

Also, in the present embodiment described above, compared with the case in which the remaining discharge time of the secondary battery 25 is estimated from only the present temperature of the secondary battery 25 without considering the change in temperature of the secondary battery 25, it is possible to increase the estimation accuracy of the remaining discharge time of the secondary battery 25.

Moreover, in the present embodiment, the heat balance model and the electric circuit model (in details, Expressions (1) to (5) described before) are used, and hence, compared with the case in which the data on the secondary battery 25 obtained in advance for each condition of the secondary battery 25 is used as in the third embodiment, a load imposed by preparation thereof can be reduced. Moreover, compared with the third embodiment, the estimation accuracy of the remaining discharge time of the secondary battery 25 can be increased.

Note that, in the first to fourth embodiments, there is exemplified the case in which the secondary battery 25 is configured by the plurality of battery modules 30 connected serially, but the configuration is not limited to this example. The secondary battery 25 may be configured by the plurality of battery modules 30 connected, for example, in parallel.

Moreover, in the first to fourth embodiments, there is exemplified the case in which the vehicle control unit 29 predicts the transitions of the temperature and the like of the secondary battery 25, predicts the transition of the current of the secondary battery 25 on the basis of the transitions of the temperature and the like of the secondary battery 25, and estimates the remaining charge time or the remaining discharge time of the secondary battery 25 on the basis of the transition of the current of the secondary battery 25, but the configuration is not limited to this example. The vehicle control unit 29 may use a map which reflects the predicted transitions of the temperature and the like of the secondary battery 25 and the predicted transition of the current of the secondary battery 25 and indicates correspondence between a condition formed of the temperature and the voltage or the state of charge of the secondary battery 25 and the like (in details, the state of health of quantity or the state of health resistance of the secondary battery 25 may be added and the temperature of the external air may be added) and the remaining charge time or the remaining discharge time of the secondary battery 25 to acquire the remaining charge time or the remaining discharge time of the secondary battery 25 from a condition formed of the temperature and the voltage or the state of charge of the secondary battery 25 and the like detected by the battery management unit **28.** As one of specific examples, the vehicle control unit 29 uses a map indicating correspondence between a condition formed of the temperature and the state of charge of the secondary battery 25 and the remaining charge time of the secondary battery 25 as illustrated Table 3 to estimate that the remaining charge time is 100 minutes when the temperature of the secondary battery 25 is 0°C and the state of charge is 20% at the charge start time of the secondary battery 25. Also, in this modification example, the estimation accuracy for the remaining charge time or the remaining discharge time of the secondary battery 25 can be increased.

[TABLE 3]

|  |  | State of charge [%] |  |  |  |
| --- | --- | --- | --- | --- | --- |
|  |  | 20 | 40 | 60 | 80 |
| Temperature [°C] | 45 | 70 | 50 | 30 | 10 |
|  | 25 | 75 | 55 | 35 | 15 |
|  | 0 | 100 | 75 | 50 | 30 |
|  | -20 | 150 | 120 | 70 | 40 |

Note that, in the description given above, there is exemplified the case in which the present invention is applied to the electrically driven excavator, but the application target is not limited to this example. That is, the present invention may be applied to other electrically driven work machine such as an electrically driven wheel loader, an electrically driven dump truck, or electrically driven road machine.

Description of Reference Characters

25: Secondary battery
28: Battery management unit
29: Vehicle control unit

**Claims**

1.  An electrically driven work machine comprising:

    a secondary battery; and
    a battery management unit that detects at least either a voltage or a state of charge of the secondary battery and a temperature of the secondary battery, wherein
    the electrically driven work machine includes a vehicle control unit that manages charge and discharge of the secondary battery, and
    the vehicle control unit is configured to
    predict a transition of the temperature of the secondary battery on a basis of the temperature and the voltage or the state of charge of the secondary battery detected by the battery management unit,
    predict a transition of a current of the secondary battery on a basis of the predicted transition of the temperature of the secondary battery, and
    estimate a remaining charge time or a remaining discharge time of the secondary battery on a basis of the predicted transition of the current of the secondary battery.

2. The electrically driven work machine according to claim 1, wherein

the battery management unit detects a state of health of the secondary battery, and
the vehicle control unit is configured to predict the transition of the temperature of the secondary battery on a basis of the state of health, the temperature, and the voltage or the state of charge of the secondary battery detected by the battery management unit.

3. The electrically driven work machine according to claim 1, wherein

the battery management unit detects the current of the secondary battery, and
the vehicle control unit is configured to predict the transition of the temperature of the secondary battery on a basis of the current, the temperature, and the voltage or the state of charge of the secondary battery detected by the battery management unit.

4. The electrically driven work machine according to claim 1, wherein

the vehicle control unit is configured to change the current of the secondary battery according to the voltage or the state of charge of the secondary battery detected by the battery management unit, at time of the charge or at time of the discharge of the secondary battery, and
the vehicle control unit is configured to
predict a transition of the voltage or the state of charge of the secondary battery on the basis of the temperature and the voltage or the state of charge of the secondary battery detected by the battery management unit, and predict the transition of the current of the secondary battery on a basis of the predicted transition of the temperature of the secondary battery and the predicted transition of the voltage or the state of charge of the secondary battery.

5. The electrically driven work machine according to claim 4, wherein

the battery management unit detects a state of health of the secondary battery, and
the vehicle control unit is configured to predict the transition of the voltage or the state of charge of the secondary battery on a basis of the state of health, the temperature, and the voltage or the state of charge of the secondary battery detected by the battery management unit.

6. The electrically driven work machine according to claim 4, wherein

the battery management unit detects the current of the secondary battery, and
the vehicle control unit is configured to predict the transition of the voltage or the state of charge of the secondary battery on a basis of the current, the temperature, and the voltage or the state of charge of the secondary battery detected by the battery management unit.

7. The electrically driven work machine according to claim 1, wherein

the battery management unit detects the current and a state of health of the secondary battery, and a temperature of an external air,
the vehicle control unit is configured to change the current of the secondary battery according to the voltage or the state of charge of the secondary battery detected by the battery management unit at time of the charge or at time of the discharge of the secondary battery, and
the vehicle control unit is configured to
use a heat balance model to predict the transition of the temperature of the secondary battery on a basis of the temperature, the voltage, and the current of the secondary battery, and the temperature of the external air detected by the battery management unit,
use an electric circuit model to predict a transition of the voltage or the state of charge of the secondary battery on a basis of the temperature, the state of charge, the state of health, and the current of the secondary battery detected by the battery management unit, and
predict the transition of the current of the secondary battery on a basis of the predicted transition of the temperature of the secondary battery and the predicted transition of the voltage or the state of charge of the secondary battery.

[FIG. 1]

[FIG. 2]

[FIG. 3]

[FIG. 4]

# [FIG. 5]

```
                    ┌──────────────┐
                    │    START     │
                    └──────────────┘
                            │
                            ▼
        ┌──────────────────────────────────────┐
S11 ──  │ PREDICT TRANSITION OF TEMPERATURE OF  │
        │          SECONDARY BATTERY            │
        └──────────────────────────────────────┘
                            │
                            ▼
        ┌──────────────────────────────────────┐
S12 ──  │    PREDICT TRANSITION OF VOLTAGE OF   │
        │          SECONDARY BATTERY            │
        └──────────────────────────────────────┘
                            │
                            ▼
        ┌──────────────────────────────────────┐
        │   PREDICT TRANSITION OF CURRENT OF    │
        │    SECONDARY BATTERY ON BASIS OF      │
S13 ──  │    TRANSITION OF TEMPERATURE OF       │
        │ SECONDARY BATTERY AND TRANSITION OF   │
        │   VOLTAGE OF SECONDARY BATTERY        │
        └──────────────────────────────────────┘
                            │
                            ▼
        ┌──────────────────────────────────────┐
        │ ESTIMATE REMAINING CHARGE TIME OF     │
        │   SECONDARY BATTERY ON BASIS OF       │
S14 ──  │ TRANSITION OF CURRENT OF SECONDARY    │
        │              BATTERY                  │
        └──────────────────────────────────────┘
                            │
                            ▼
                    ┌──────────────┐
                    │     END      │
                    └──────────────┘
```

[FIG. 6A]

TEMPERATURE

TIME

[FIG. 6B]

VOLTAGE

TIME

[FIG. 6C]

CURRENT

FIRST EMBODIMENT OF
PRESENT INVENTION

PRIOR ART

TIME

[FIG. 7]

ESTIMATED VALUE IN COMPARATIVE EXAMPLE

ESTIMATED VALUE IN FIRST
EMBODIMENT OF PRESENT INVENTION

ACTUALLY
MEASURED
VALUE

REMAINING CHARGE TIME [MINUTE]

ELAPSED TIME [MINUTE]

[FIG. 8]

CURRENT

TIME

# [FIG. 9]

```
                    ┌─────────────┐
                    │    START    │
                    └──────┬──────┘
                           │
                    ┌──────▼──────┐
      S21───────────┤     k=1     │
                    └──────┬──────┘
                           │
         ┌─────────────────▼─────────────────┐
 S22─────┤ PREDICT TEMPERATURE OF SECONDARY  │
         │    BATTERY AFTER X MINUTES         │
         └─────────────────┬─────────────────┘
                           │
         ┌─────────────────▼─────────────────┐
 S23─────┤ PREDICT VOLTAGE OF SECONDARY       │
         │    BATTERY AFTER X MINUTES         │
         └─────────────────┬─────────────────┘
                           │
         ┌─────────────────▼─────────────────┐
         │   PREDICT CURRENT OF SECONDARY     │
         │ BATTERY AFTER (X*k) MINUTES ON     │
 S24─────┤ BASIS OF TEMPERATURE OF SECONDARY  │
         │ BATTERY AFTER (X*k) MINUTES AND    │
         │ VOLTAGE OF SECONDARY BATTERY       │
         │      AFTER (X*k) MINUTES           │
         └─────────────────┬─────────────────┘
                           │
         ┌─────────────────▼─────────────────┐
 S25─────┤ PREDICT TEMPERATURE OF SECONDARY  │
         │  BATTERY AFTER (X*(k+1)) MINUTES   │
         └─────────────────┬─────────────────┘
                           │
         ┌─────────────────▼─────────────────┐      S28
 S26─────┤ PREDICT VOLTAGE OF SECONDARY       │    ┌────────┐
         │  BATTERY AFTER (X*(k+1)) MINUTES   │    │ k=k+1  │
         └─────────────────┬─────────────────┘    └────────┘
                           │
      S27        ◇─────────▼─────────◇    NO
              ◇  DOES SECONDARY        ◇───────────┘
           ◇  BATTERY AFTER (X*(k+1)) MINUTES ◇
              ◇  COMPLETE CHARGE?     ◇
                 ◇─────────┬─────────◇
                           │ YES
         ┌─────────────────▼─────────────────┐
 S29─────┤  ESTIMATE (X*(k+1)) MINUTES AS     │
         │    REMAINING CHARGE TIME           │
         └─────────────────┬─────────────────┘
                           │
                    ┌──────▼──────┐
                    │     END     │
                    └─────────────┘
```

# [FIG. 10]

CURRENT

STATE OF
CHARGE
HIGH

STATE OF
CHARGE
LOW

T1    T2    TEMPERATURE

# [FIG. 11]

START

S31 — PREDICT TRANSITION OF TEMPERATURE OF SECONDARY BATTERY

S32 — PREDICT TRANSITION OF VOLTAGE OF SECONDARY BATTERY

S33 — PREDICT TRANSITION OF CURRENT OF SECONDARY BATTERY ON BASIS OF TRANSITION OF TEMPERATURE OF SECONDARY BATTERY AND TRANSITION OF VOLTAGE OF SECONDARY BATTERY

S34 — ESTIMATE REMAINING DISCHARGE TIME OF SECONDARY BATTERY ON BASIS OF TRANSITION OF CURRENT OF SECONDARY BATTERY

END

# [FIG. 12]

```
                          ┌──────────┐
                          │  START   │
                          └────┬─────┘
                               │
                          ┌────▼─────┐
              S41────────┤   k=1    │
                          └────┬─────┘
                               │
          ┌────────────────────▼────────────────────┐
  S42────┤ PREDICT TEMPERATURE OF SECONDARY         │
          │    BATTERY AFTER X MINUTES              │
          └────────────────────┬────────────────────┘
                               │
          ┌────────────────────▼────────────────────┐
  S43────┤  PREDICT VOLTAGE OF SECONDARY            │
          │    BATTERY AFTER X MINUTES              │
          └────────────────────┬────────────────────┘
                               │◄───────────────────────────┐
          ┌────────────────────▼────────────────────┐       │
          │ PREDICT CURRENT OF SECONDARY            │       │
          │ BATTERY AFTER (X*k) MINUTES ON          │       │
  S44────┤ BASIS OF TEMPERATURE OF SECONDARY       │       │
          │ BATTERY AFTER (X*k) MINUTES AND         │       │
          │ VOLTAGE OF SECONDARY BATTERY           │       │
          │    AFTER (X*k) MINUTES                 │       │
          └────────────────────┬────────────────────┘       │
                               │                            │
          ┌────────────────────▼────────────────────┐       │
  S45────┤ PREDICT TEMPERATURE OF SECONDARY         │       │
          │  BATTERY AFTER (X*(k+1)) MINUTES        │       │
          └────────────────────┬────────────────────┘       │
                               │                       S48  │
          ┌────────────────────▼────────────────────┐   ┌──────────┐
  S46────┤ PREDICT VOLTAGE OF SECONDARY            │   │  k=k+1   │
          │  BATTERY AFTER (X*(k+1)) MINUTES        │   └────▲─────┘
          └────────────────────┬────────────────────┘        │
                               │                             │
    S47                        │                             │
          ╱────────────────────▼────────────────────╲   NO   │
         ╱        DOES SECONDARY                      ╲───────┘
         ╲ BATTERY AFTER (X*(k+1)) MINUTES           ╱
          ╲        STOP DISCHARGE?                  ╱
           ╲────────────────────┬────────────────────╱
                               │ YES
          ┌────────────────────▼────────────────────┐
  S49────┤ ESTIMATE (X*(k+1)) MINUTES AS           │
          │   REMAINING DISCHARGE TIME              │
          └────────────────────┬────────────────────┘
                               │
                          ┌────▼─────┐
                          │   END    │
                          └──────────┘
```

## INTERNATIONAL SEARCH REPORT

| International application No. |
|---|
| **PCT/JP2023/036274** |

**A. CLASSIFICATION OF SUBJECT MATTER**

*H02J 7/00*(2006.01)i; *B60L 3/00*(2019.01)i; *B60L 50/60*(2019.01)i; *B60L 58/12*(2019.01)i; *B60L 58/16*(2019.01)i; *E02F 9/00*(2006.01)i; *G01R 31/388*(2019.01)i; *G01R 31/392*(2019.01)i; *H01M 10/48*(2006.01)i
FI:     H02J7/00 M; B60L3/00 S; B60L50/60; B60L58/12; B60L58/16; E02F9/00 C; G01R31/388; G01R31/392; H01M10/48 P; H01M10/48 301; H02J7/00 P

According to International Patent Classification (IPC) or to both national classification and IPC

**B. FIELDS SEARCHED**

Minimum documentation searched (classification system followed by classification symbols)

H02J7/00-7/12; H02J7/34-7/36; B60L1/00-3/12; B60L7/00-13/00; B60L15/00-58/40; E02F9/00-9/18; E02F9/24-9/28; G01R31/36-31/396; H01M10/42-10/48

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| Y | WO 2018/235325 A1 (HITACHI AUTOMOTIVE SYSTEMS LTD) 27 December 2018 (2018-12-27) paragraphs [0011]-[0059], fig. 1-6 | 1-3 |
| A | paragraphs [0011]-[0059], fig. 1-6 | 4-7 |
| Y | JP 2022-516264 A (LG ENERGY SOLUTION, LTD.) 25 February 2022 (2022-02-25) paragraphs [0011]-[0071], fig. 1-3 | 1-3 |
| A | paragraphs [0011]-[0071], fig. 1-3 | 4-7 |
| Y | WO 2020/137553 A1 (HITACHI CONSTRUCTION MACH CO) 02 July 2020 (2020-07-02) paragraphs [0019]-[0040], fig. 1-3 | 1-3 |
| A | paragraphs [0019]-[0040], fig. 1-3 | 4-7 |
| A | JP 10-172616 A (SANYO ELECTRIC CO LTD) 26 June 1998 (1998-06-26) entire text, all drawings | 1-7 |

☑ Further documents are listed in the continuation of Box C.      ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **07 December 2023** | **19 December 2023** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (January 2015)

## INTERNATIONAL SEARCH REPORT

| International application No. |
| :-- |
| **PCT/JP2023/036274** |

**C.    DOCUMENTS CONSIDERED TO BE RELEVANT**

| Category* | Citation of document, with indication, where appropriate, of the relevant passages | Relevant to claim No. |
| :---: | :--- | :---: |
| A | JP 2006-101674 A (TOYOTA MOTOR CORP) 13 April 2006 (2006-04-13) entire text, all drawings | 1-7 |
| A | JP 2006-304572 A (MATSUSHITA ELECTRIC WORKS LTD) 02 November 2006 (2006-11-02) entire text, all drawings | 1-7 |
| A | CN 112798966 A (SVOLT ENERGY TECHNOLOGY COMPANY LIMITED) 14 May 2021 (2021-05-14) entire text, all drawings | 1-7 |

Form PCT/ISA/210 (second sheet) (January 2015)

**INTERNATIONAL SEARCH REPORT**
Information on patent family members

International application No.

**PCT/JP2023/036274**

| Patent document cited in search report | | | Publication date (day/month/year) | Patent family member(s) | | | Publication date (day/month/year) |
|---|---|---|---|---|---|---|---|
| WO | 2018/235325 | A1 | 27 December 2018 | JP | 2019-008907 | A | |
| JP | 2022-516264 | A | 25 February 2022 | US | 2021/0370796 | A1 | |
| | | | | paragraphs [0011]-[0071], fig. 1-3 | | | |
| | | | | WO | 2021/045387 | A1 | |
| | | | | EP | 3923007 | A1 | |
| | | | | KR | 10-2021-0029878 | A | |
| | | | | CN | 113784868 | A | |
| WO | 2020/137553 | A1 | 02 July 2020 | JP | 2020-108283 | A1 | |
| JP | 10-172616 | A | 26 June 1998 | US | 5926007 | A | |
| | | | | entire text, all drawings | | | |
| | | | | TW | 347598 | B | |
| JP | 2006-101674 | A | 13 April 2006 | JP | 2008-271781 | A | |
| JP | 2006-304572 | A | 02 November 2006 | (Family: none) | | | |
| CN | 112798966 | A | 14 May 2021 | (Family: none) | | | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2020036393 A